# EUROPEAN PATENT APPLICATION

(11) **EP 1 524 689 A1**
(43) Date of publication of application: **20.04.2005**
(21) Application number: 02755645.5
(22) Date of filing: 24.07.2002
(51) Int. Cl.: H01L 23/12

(54) **SEMICONDUCTOR DEVICE**

(71) Applicant: MITSUBISHI DENKI KABUSHIKI KAISHA, Tokyo 100-8310 (JP)
(72) Inventor: NINOMIYA, Keiji, Chiyoda-ku, Tokyo 100-8310 (JP); ITOH, Kenji, Chiyoda-ku, Tokyo 100-8310 (JP); JOBA, Hiroyuki, Chiyoda-ku, Tokyo 100-8310 (JP)
(74) Representative: Bohnenberger, Johannes, Dr.
(86) International application number: PCT/JP2002/007513
(87) International publication number: WO 2004/010497

(57) **Abstract**

The present invention relates to a semiconductor device and, more particularly, has for its object to provide a technique for improving the performance of a semiconductor device having a ground terminal and a plurality of signal terminals arranged around the ground terminal.

To attain the object, the present invention features isolation between a ground terminal (5, 35) connected to a functional block (11) and a ground terminal (6, 36) connected to a functional block (12). Thus, a ground potential applied to one of the functional blocks through the corresponding ground terminal is prevented from varying depending on the magnitude of a current flowing through the other functional block. This improves the performance of each functional block to improve the performance of the semiconductor device.

## Description

### Technical Field

The present invention relates to a semiconductor device and, more particularly, to a semiconductor device having a ground terminal and a plurality of signal terminals arranged around the ground terminal.

### Background Art

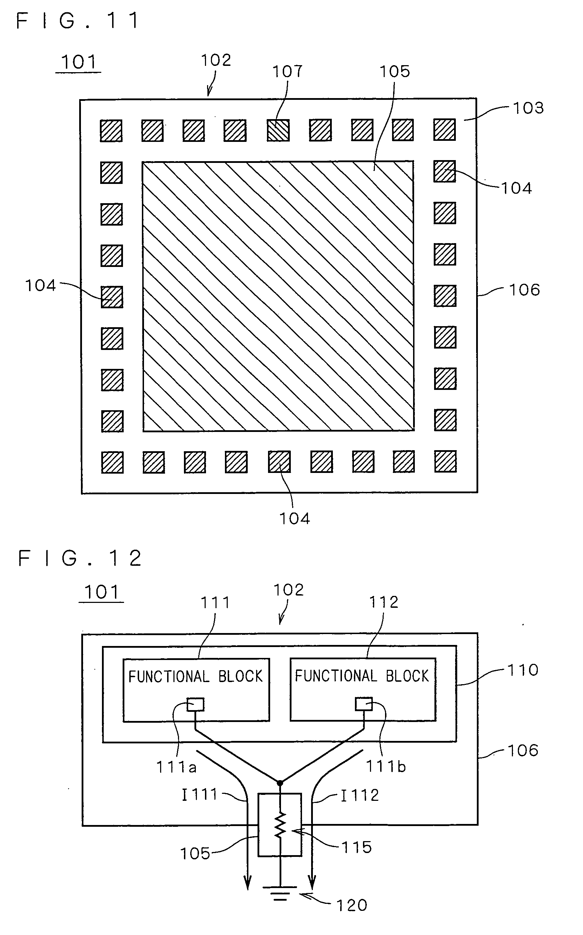

Fig. 11 is a plan view showing the structure of a conventional semiconductor device 101, and illustrates the appearance thereof as viewed from the bottom thereof. Fig. 12 is a block diagram showing the construction of the conventional semiconductor device 101 in which a power supply terminal 107 and signal terminals 104 shown in Fig. 11 are not illustrated for simplicity.

As shown in Figs. 11 and 12, the conventional semiconductor device 101 comprises a semiconductor integrated circuit 110 including a plurality of functional blocks, a package 102 for storing the semiconductor integrated circuit 110 therein, and a single ground terminal 105, the plurality of signal terminals 104 and the power supply terminal 107 which are exposed to the outside of the package 102.

The semiconductor integrated circuit 110 includes a functional block 111 which is, for example, a digital circuit, and a functional block 112 which is, for example, an analog circuit. The functional block 111 is provided with an electrode (referred to hereinafter as an "electrode 111a") for receiving a ground potential on which the operation of the functional block 111 is based, and the functional block 112 is provided with an electrode (referred to hereinafter as an "electrode 112a") for receiving the ground potential on which the operation of the functional block 112 is based.

The package 102 is made of molding resin 103 defining the outer shape 106 of the semiconductor device 101. The molding resin 103 seals the ground terminal 105, the power supply terminal 107 and the signal terminals 104 while exposing the ground terminal 105, the power supply terminal 107 and the signal terminals 104.

The ground terminal 105, the power supply terminal 107 and the signal terminals 104 are provided on the bottom surface of the package 102, and the power supply terminal 107 and the signal terminals 104 are arranged around the ground terminal 105. As shown in Fig. 12, the ground terminal 105 is electrically connected to the above-mentioned electrodes 111a and 112a within the package 102, and a ground potential 120 is applied from the outside of the semiconductor device 101 to the ground terminal 105. This establishes an electrical connection between the ground terminal 105 and the functional blocks 111 and 112, to allow the functional blocks 111 and 112 to receive the ground potential on which the operation of the functional blocks 111 and 112 is based, through the ground terminal 105.

Although not shown in Fig. 12, each of the signal terminals 104 is electrically connected to the functional block 111 or the functional block 112 within the package 102. A clock signal on which the operation of the digital circuit is based or some other input signal, for example, is applied from the outside of the semiconductor device 101 to one of the signal terminals 104 which is connected to the functional block 111. As a result, the external input signal is provided to the functional block 111. An output signal from the functional block 111 is provided to another of the signal terminals 104 which is connected to the functional block 111. This allows a device external to the semiconductor device 101 to receive the output signal from the functional block 111.

A high-frequency signal, for example, received by an antenna (not shown) is applied from the outside of the semiconductor device 101 to one of the signal terminals 104 which is connected to the functional block 112. As a result, the high-frequency signal is provided to the functional block 112. An output signal from the functional block 112 is provided to another of the signal terminals 104 which is connected to the functional block 112. The signal terminals 104 which receive signals from the outside of the semiconductor device 101 are also referred to hereinafter as "input signal terminals 104," and the signal terminals 104 which receive output signals from the functional blocks 111 and 112 are also referred to hereinafter as "output signal terminals 104."

Although not shown in Fig. 12, the power supply terminal 107 is electrically connected to the functional block 111 and the functional block 112 within the package 102. Power, e.g. a positive potential, required to operate the semiconductor integrated circuit 110 is applied from the outside of the semiconductor device 101 to the power supply terminal 107. This provides power to the functional blocks 111 and 112 through the power supply terminal 107, and the functional blocks 111 and 112 operate on the basis of the ground potential applied through the ground terminal 105.

When the semiconductor integrated circuit 110 operates, currents I111 and I112 flow through the functional blocks 111 and 112, respectively. The currents I111 and I112 flow from the power supply terminal 107, the input signal terminals 104 or the output signal terminals 104 to the ground terminal 105.

When the currents I111 and I112 flow through the ground terminal 105, an impedance 115, such as resistance and inductance, of the ground terminal 105 gives rise to a potential difference between the ground potential 120 applied from the outside of the semiconductor device 101 to the ground terminal 105 and a ground potential actually applied to the electrodes 111a and 112a. Since both of the currents I111 and I112 flow to the ground terminal 105, the potential difference varies depending on the magnitudes of the respective currents I111 and I112. In other words, the ground potential applied to one of the functional blocks 111 and 112 varies depending on not only the magnitude of the current flowing through the one functional block itself but also the magnitude of the current flowing through the other functional block. Thus, degradation might occur in performance of the one functional block due to the magnitude of the current flowing through the other functional block, resulting in degradation in performance of the entire semiconductor device 101.

### Disclosure of Invention

The present invention has been made to solve the above-mentioned problems. It is therefore an object of the present invention to provide a technique for improving the performance of a semiconductor device.

According to a first aspect of the present invention, a semiconductor device comprises: a semiconductor integrated circuit having a first functional block and a second functional block; a package for storing the semiconductor integrated circuit therein; and a ground terminal and signal terminals exposed to the outside of the package, the ground terminal including first and second ground terminals isolated from each other, the signal terminals includes a plurality of first signal terminals arranged around the ground terminal, the first ground terminal being electrically connected to the first functional block, the second ground terminal being electrically connected to the second functional block.

In the semiconductor device according to a second aspect of the present invention, the second ground terminal surrounds the first ground terminal.

In the semiconductor device according to a third aspect of the present invention, the signal terminals include a second signal terminal, and the second ground terminal further surrounds the second signal terminal.

In the semiconductor device according to the first aspect of the present invention, the first ground terminal connected to the first functional block is isolated from the second ground terminal connected to the second functional block. Thus, a ground potential applied to one of the functional blocks through the corresponding ground terminal is prevented from varying depending on the magnitude of a current flowing through the other functional block. This improves the performance of each of the first and second functional blocks to improve the performance of the semiconductor device.

In the semiconductor device according to the second aspect of the present invention, the second ground terminal surrounds the first ground terminal. Therefore, the potential at the first ground terminal is less susceptible to a potential change at the first signal terminals.

In the semiconductor device according to the third aspect of the present invention, the second ground terminal further surrounds the second signal terminal. Therefore, the potentials at not only the first ground terminal but also the second signal terminal are less susceptible to a potential change at the first signal terminals.

These and other objects, features, aspects and advantages of the present invention will become more apparent from the following detailed description of the present invention when taken in conjunction with the accompanying drawings.

### Brief Description of Drawings

Fig. 1 is a plan view showing the structure of a semiconductor device according to a first embodiment of the present invention.
Fig. 2 is a block diagram showing the construction of the semiconductor device according to the first embodiment of the present invention.
Fig. 3 is a plan view showing the structure of the semiconductor device according to the first embodiment of the present invention.
Fig. 4 is a sectional view showing the structure of the semiconductor device according to the first embodiment of the present invention.
Fig. 5 is a plan view showing the structure of the semiconductor device according to a second embodiment of the present invention.
Fig. 6 is a plan view showing the structure of the semiconductor device according to the second embodiment of the present invention.
Fig. 7 is a sectional view showing the structure of the semiconductor device according to the second embodiment of the present invention.
Fig. 8 is a plan view showing the structure of the semiconductor device according to a third embodiment of the present invention.
Fig. 9 is a plan view showing the structure of the semiconductor device according to the third embodiment of the present invention.
Fig. 10 is a sectional view showing the structure of the semiconductor device according to the third embodiment of the present invention.
Fig. 11 is a plan view showing the structure of a conventional semiconductor device.
Fig. 12 is a block diagram showing the construction of the conventional semiconductor device.

### Best Modes for Carrying Out the Invention

### 1. First Embodiment

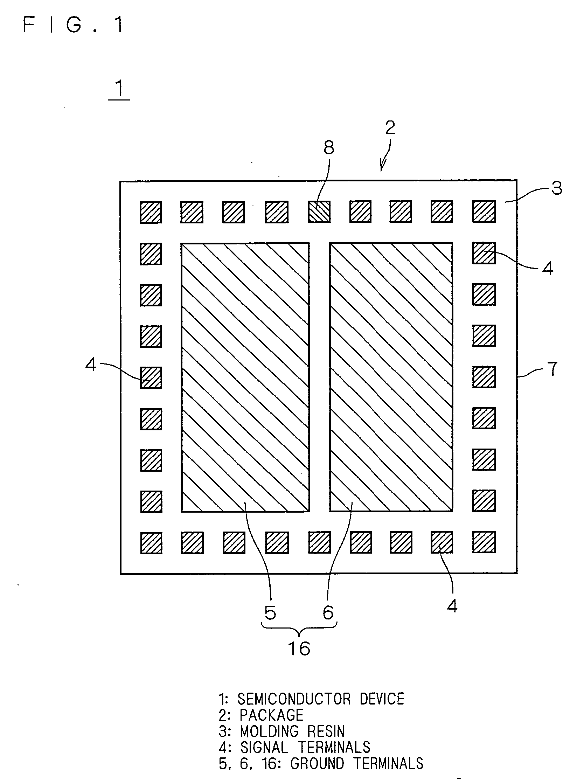

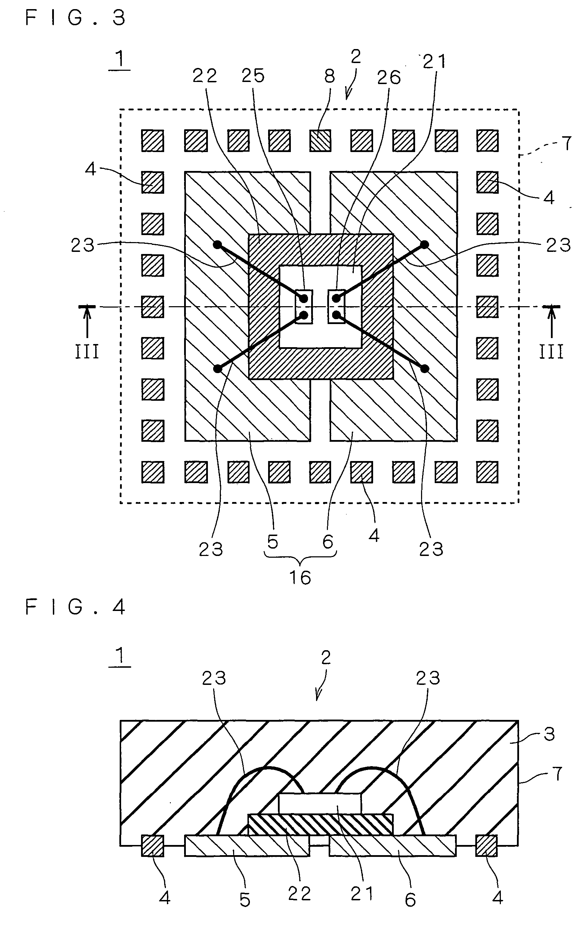

Figs. 1 and 3 are plan views showing the structure of a semiconductor device 1 according to a first embodiment of the present invention. Fig. 4 is a sectional view taken along the line III-III of Fig. 3. Fig. 1 illustrates the appearance of the semiconductor device 1 as viewed from the bottom, and Fig. 3 illustrates the interior of the semiconductor device 1 as viewed from the top. In Fig. 3, molding resin 3 shown in Fig. 1 is omitted for illustration of the interior structure of the semiconductor device 1, and the outer shape 7 of the semiconductor device 1 is indicated by broken lines.

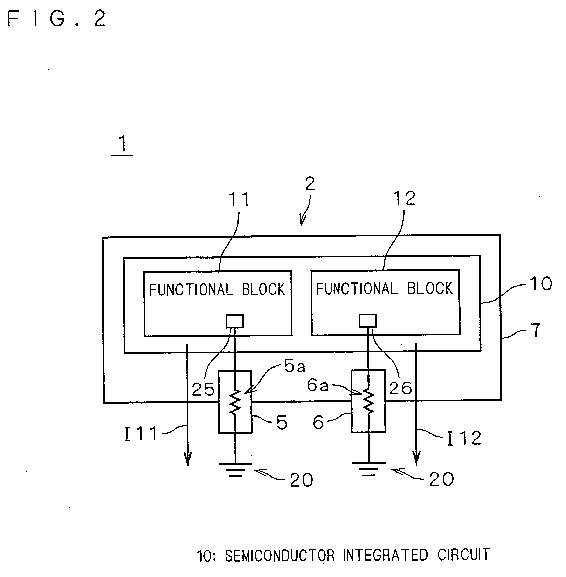

Fig. 2 is a block diagram showing the construction of the semiconductor device 1 according to the first embodiment, wherein a power supply terminal 8 and signal terminals 4 shown in Fig. 1 are omitted for simplicity.

As shown in Figs. 1 to 4, the semiconductor device 1 according to the first embodiment comprises a semiconductor integrated circuit 10 having a plurality of functional blocks, a package 2 for storing the semiconductor integrated circuit 10 therein, and a ground terminal 66, the plurality of signal terminals 4 and the single power supply terminal 8 which are exposed to the outside of the package 2.

The semiconductor integrated circuit 10 is formed on a semiconductor chip 21, and includes, for example, two functional blocks 11 and 12. The functional block 11 includes, for example, a digital circuit, and the functional block 12 includes, for example, an analog circuit. Specifically, when the semiconductor device 1 according to the first embodiment is adopted, for example, as a receiver for a digital modulated signal, the functional block 12 is constituted by an analog circuit including a filter circuit for extracting a desired signal from the received signal and an amplifier circuit for amplifying the output from the filter circuit, and the functional block 11 is constituted by a digital circuit including a decoder for making an error correction and the like on a demodulated digital signal.

On the upper surface of the semiconductor chip 21 as shown in Fig. 3, an electrode 25 for receiving a ground potential on which the operation of the functional block 11 is based is provided in a region (not shown) wherein the functional block 11 is formed, and an electrode 26 for receiving the ground potential on which the operation of the functional block 12 is based is provided in a region (not shown) wherein the functional block 12 is formed. The semiconductor chip 21 has a lower surface bonded to an insulating substrate 22, as shown in Fig. 4. The insulating substrate 22 includes, for example, a glass epoxy substrate or a Teflon substrate.

The package 2 of the semiconductor device 1 is made of the molding resin 3 defining the outer shape 7 of the semiconductor device 1, as shown in Fig. 1. The ground terminal 16 includes ground terminals 5 and 6 isolated from each other and arranged adjacent to each other. The ground terminal 16, the power supply terminal 8 and the signal terminals 4 are provided on the bottom surface of the package 2, and the power supply terminal 8 and the signal terminals 4 are arranged around the ground terminal 16.

As shown in Figs. 3 and 4, the insulating substrate 22 with the semiconductor chip 21 bonded thereto is bonded to the ground terminals 5 and 6 on the opposite side from the semiconductor chip 21. In other words, the insulating substrate 22 and the semiconductor chip 21 are mounted in the order named on the ground terminals 5 and 6.

Each of the ground terminals 5 and 6 is, for example, a rectangular metal sheet. As shown in Figs. 2 to 4, the ground terminals 5 and 6 are bonded by aluminum wires 23 to the electrodes 25 and 26, respectively, of the semiconductor chip 21 within the package 2. This provides an electrical connection between the ground terminal 5 and the functional block 11, and an electrical connection between the ground terminal 6 and the functional block 12.

As shown in Fig. 2, the ground potential is applied from the outside of the semiconductor device 1 to each of the ground terminals 5 and 6. As a result, each of the functional blocks 11 and 12 receives the ground potential on which the operation thereof is based.

Each of the signal terminals 4 is, for example, a rectangular metal sheet. Although not shown in Figs. 2 to 4, electrodes for receiving output signals from the functional blocks 11 and 12 or electrodes for applying signals from the outside of the semiconductor device 1 to the functional blocks 11 and 12 are provided around the upper surface of the semiconductor chip 21. The signal terminals 4 are electrically connected to the above-mentioned electrodes, respectively, through aluminum wires. Thus, each of the signal terminals 4 is electrically connected to the functional block 11 or the functional block 12 within the package 2.

A clock signal on which the operation of the digital circuit is based or some other input signal, for example, is applied from the outside of the semiconductor device 1 to one of the signal terminals 4 which is connected to the functional block 11. As a result, the external input signal is provided to the functional block 11. An output signal from the functional block 11 is provided to another of the signal terminals 4 which is connected to the functional block 11. This allows a device external to the semiconductor device 1 to receive the output signal from the functional block 1.

A high-frequency signal, for example, received by an antenna (not shown) is applied from the outside of the semiconductor device 1 to one of the signal terminals 4 which is connected to the functional block 12. As a result, the high-frequency signal is provided to the functional block 12. An output signal from the functional block 12 is applied to another of the signal terminals 4 which is connected to the functional block 12. The signal terminals 4 which receive signals from the outside of the semiconductor device 1 are also referred to hereinafter as "input signal terminals 4," and the signal terminals 4 which receive output signals from the functional blocks 111 and 112 are also referred to hereinafter as "output signal terminals 4."

The power supply terminal 8 is, for example, a rectangular metal sheet. Although not shown in Figs. 2 to 4, electrodes for supplying power from the outside of the semiconductor device 1 to the functional blocks 11 and 12 are provided on the upper surface of the semiconductor chip 21. The power supply terminal 8 is electrically connected to the above-mentioned electrodes through aluminum wires. Thus, the power supply terminal 8 is electrically connected to the functional block 11 and the functional block 12 within the package 2.

Power, e.g. a positive potential, required to operate the semiconductor integrated circuit 10 is applied from the outside of the semiconductor device 1 to the power supply terminal 8. This provides power to the functional blocks 11 and 12 through the power supply terminal 7. Thus, the functional block 11 operates on the basis of the ground potential applied thereto through the ground terminal 5, and the functional block 12 operates on the basis of the ground potential applied thereto through the ground terminal 6.

As shown in Figs. 1 and 4, the molding resin 3 seals the semiconductor chip 21, the insulating substrate 22, the ground terminals 5 and 6, the power supply terminal 8, the signal terminals 4 and the aluminum wires 23 while exposing the ground terminals 5 and 6, the power supply terminal 8 and the signal terminals 4.

When the semiconductor integrated circuit 10 is powered from the outside of the semiconductor device 1 as described above to start operating, currents I11 and I12 flow through the functional blocks 11 and 12, respectively. The current I11 through the functional block 11 flows from the power supply terminal 8, the input signal terminals 4 or the output signal terminals 4 to the ground terminal 5. The current I12 through the functional block 12 flows from the power supply terminal 8, the input signal terminals 4 or the output signal terminals 4 to the ground terminal 6.

Since the ground terminal 5 is isolated from the ground terminal 6, the current I11 does not flow into the ground terminal 6, and the current I12 does not flow into the ground terminal 5. Thus, when current flows to the ground terminal 5 and the impedance 5a of the ground terminal 5 gives rise to a potential difference between a ground potential 20 applied from the outside of the semiconductor device 1 to the ground terminal 5 and a ground potential actually applied to the electrode 25, the potential difference does not vary depending on the magnitude of the current l12. Likewise, when current flows to the ground terminal 6 and the impedance 6a of the ground terminal 6 gives rise to a potential difference between the ground potential 20 applied from the outside of the semiconductor device 1 to the ground terminal 6 and a ground potential actually applied to the electrode 26, the potential difference does not vary depending on the magnitude of the current I11.

Therefore, the ground potential applied to one of the functional blocks 11 and 12 varies depending on only the magnitude of the current flowing through the one functional block itself, and is not affected by the magnitude of the current flowing through the other functional block.

In the semiconductor device 1 according to the first embodiment, as described above, the ground terminals for the respective functional blocks of the semiconductor integrated circuit 10 are isolated from each other. Unlike the above-mentioned conventional semiconductor device 101, the semiconductor device 1 prevents the ground potential applied to one of the functional blocks through the corresponding ground terminal from varying depending on the magnitude of the current flowing through the remainder of the functional blocks. This improves the performance of each of the functional blocks. Therefore, the semiconductor device 1 according to the first embodiment achieves higher performance than the conventional semiconductor device 101.

### 2. Second Embodiment

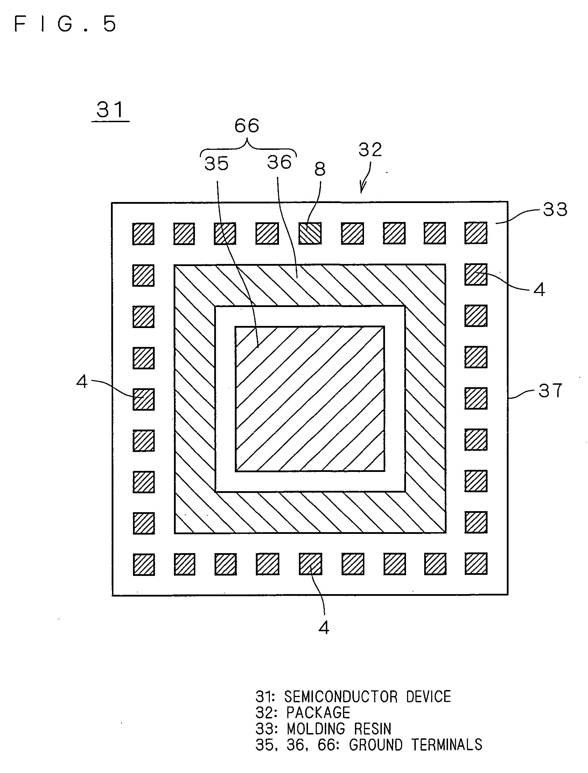

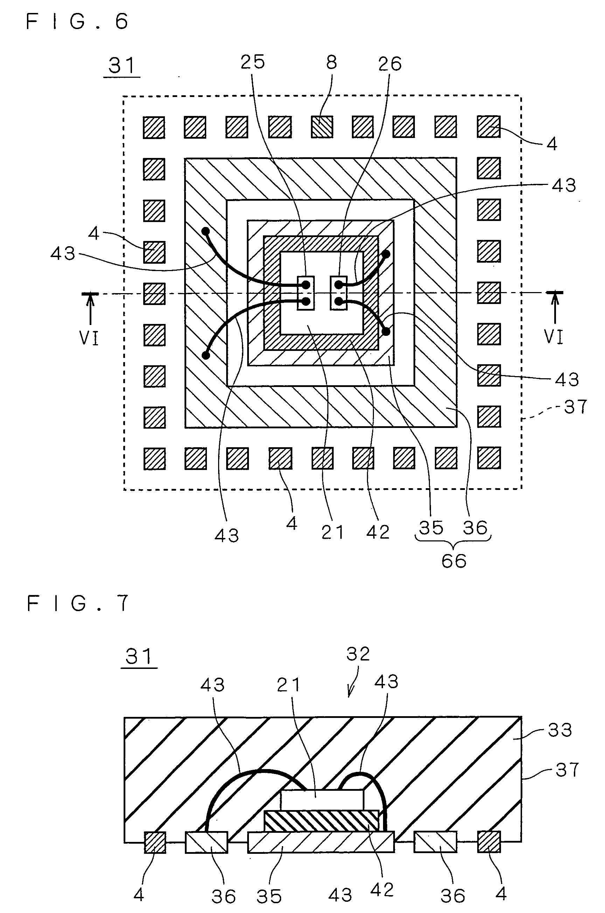

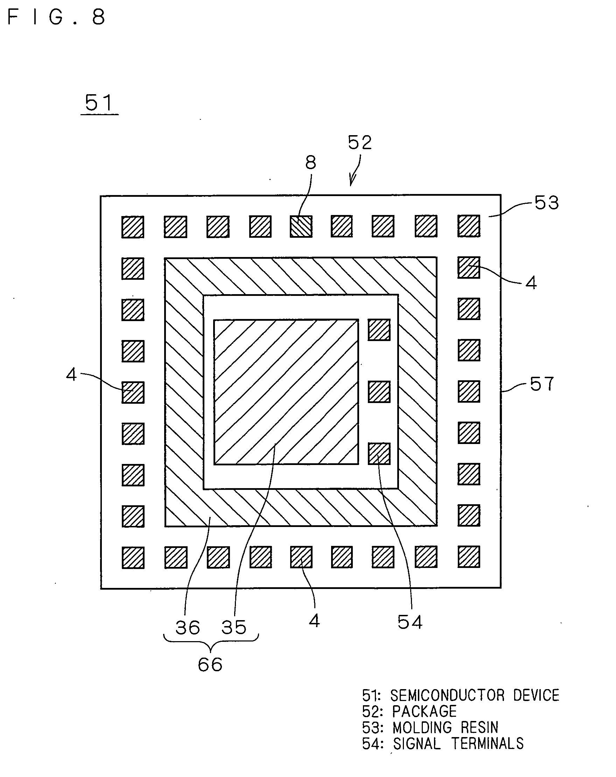

Figs. 5 and 6 are plan views showing the structure of a semiconductor device 31 according to a second embodiment of the present invention. Fig. 7 is a sectional view taken along the line VI-VI of Fig. 6. Fig. 5 illustrates the appearance of the semiconductor device 31 as viewed from the bottom, and Fig. 6 illustrates the interior of the semiconductor device 31 as viewed from the top. In Fig. 6, molding resin 33 shown in Fig. 5 is omitted for illustration of the interior structure of the semiconductor device 31, and the outer shape 37 of the semiconductor device 31 is indicated by broken lines.

The semiconductor device 31 according to the second embodiment is basically such that the ground terminals 5 and 6 of the semiconductor device 1 according to the first embodiment are modified in shape.

The semiconductor device 1 according to the second embodiment comprises the above-mentioned semiconductor integrated circuit 10, a package 32 for storing the semiconductor integrated circuit 10 therein, and a ground terminal 66, the plurality of signal terminals 4 and the power supply terminal 8 which are exposed to the outside of the package 32.

The package 32 of the semiconductor device 31 is made of the molding resin 33 defining the outer shape 37 of the semiconductor device 31, as shown in Fig. 5. The ground terminal 66 includes ground terminals 35 and 36 isolated from each other. The ground terminal 66, the power supply terminal 8 and the signal terminals 4 are provided on the bottom surface of the package 32.

The ground terminal 35 is such that the ground terminal 5 according to the first embodiment is modified in shape, and is, for example, a substantially square metal sheet. The ground terminal 36 is such that the ground terminal 6 according to the first embodiment is modified in shape, and is, for example, a metal sheet having the shape of a square frame. The ground terminal 36 surrounds the ground terminal 35, and the power supply terminal 8 and the signal terminals 4 are arranged around the ground terminal 66.

As shown in Figs. 6 and 7, an insulating substrate 42 with the semiconductor chip 21 bonded thereto is bonded to the ground terminal 35 on the opposite side from the semiconductor chip 21. In other words, the insulating substrate 42 and the semiconductor chip 21 are mounted in the order named on the ground terminal 35. The insulating substrate 42 includes, for example, a glass epoxy substrate or a Teflon substrate.

As shown in Figs. 6 and 7, the ground terminals 35 and 36 are bonded by aluminum wires 43 to the electrodes 25 and 26, respectively, of the semiconductor chip 21 within the package 2. This provides an electrical connection between the ground terminal 35 and the functional block 11, and an electrical connection between the ground terminal 36 and the functional block 12. The size of the insulating substrate 42 smaller than that of the ground terminal 35 allows the connection through the aluminum wires 43 between the electrode 26 formed on the upper surface of the semiconductor chip 21 and the ground terminal 35.

As shown in Figs. 5 and 7, the molding resin 33 seals the semiconductor chip 21, the insulating substrate 42, the ground terminal 66, the power supply terminal 8, the signal terminals 4 and the aluminum wires 43 while exposing the ground terminal 66, the power supply terminal 8 and the signal terminals 4. The remaining structures of the semiconductor device 31 according to the second embodiment are similar to those of the semiconductor device 1 according to the first embodiment, and will not be described.

In the semiconductor device 31 according to the second embodiment, as described above, the ground terminal 36 surrounds the ground terminal 35. Thus, the potential at the ground terminal 35 is less susceptible to a potential change at the signal terminals 4.

The semiconductor device 1 according to the first embodiment has the ground terminals 5 and 6 both rectangular in shape and arranged merely adjacent to each other. Thus, when a clock signal of, e.g., tens of megahertz is inputted to one of the signal terminals 4, a potential change at the one signal terminal 4 might vary the potential at one or both of the ground terminals 5 and 6, to result in the degradation of the performance of the functional block connected to the ground terminal(s) varied in potential.

The second embodiment, in which one of the ground terminals surrounds the other ground terminal, can reduce the variations in potential at the other ground terminal at least due to the potential change at the signal terminals 4. Consequently, the semiconductor device 32 achieves higher performance than the semiconductor device 1 of the first embodiment.

### 3. Third Embodiment

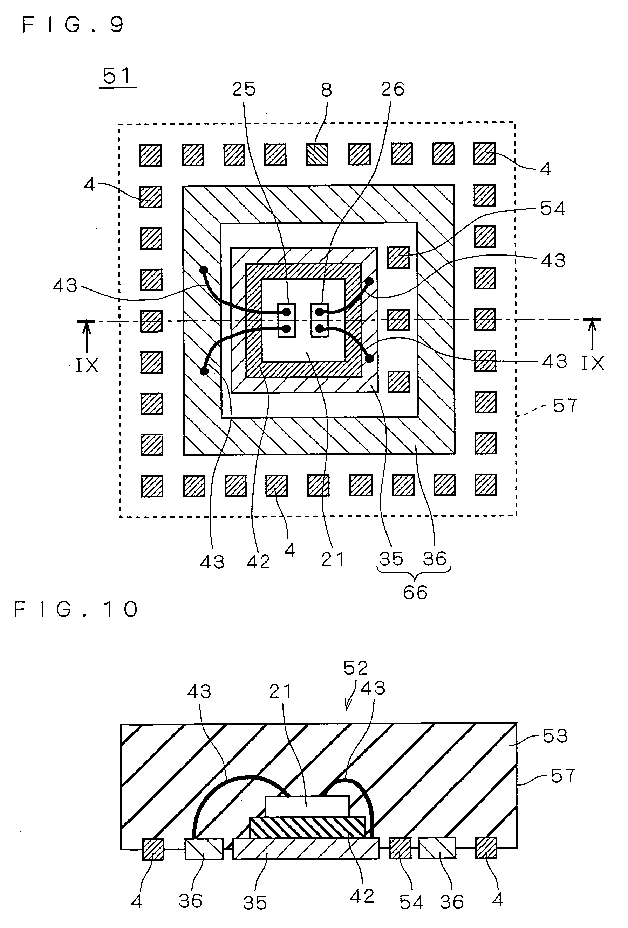

Figs. 8 and 9 are plan views showing the structure of a semiconductor device 51 according to a third embodiment of the present invention. Fig. 10 is a sectional view taken along the line IX-IX of Fig. 9. Fig. 8 illustrates the appearance of the semiconductor device 51 as viewed from the bottom, and Fig. 9 illustrates the interior of the semiconductor device 51 as viewed from the top. In Fig. 9, molding resin 53 shown in Fig. 8 is omitted for illustration of the interior structure of the semiconductor device 51, and the outer shape 57 of the semiconductor device 51 is indicated by broken lines.

The semiconductor device 51 according to the third embodiment is such that signal terminals are added to the semiconductor device 31 according to the second embodiment, and the ground terminal 36 also surrounds the signal terminals.

The semiconductor device 51 according to the third embodiment comprises the above-mentioned semiconductor integrated circuit 10, a package 52 for storing the semiconductor integrated circuit 10 therein, and the ground terminal 66, the signal terminals 4 and 54 and the power supply terminal 8 which are exposed to the outside of the package 52. The package 52 is made of the molding resin 53 defining the outer shape 57 of the semiconductor device 51, as shown in Fig. 8.

Each of the plurality of signal terminals 54 is, for example, a rectangular metal sheet. Like the signal terminals 4, each of the signal terminals 54 is electrically connected to the functional block 11 or the functional block 12 within the package 2. Specifically, the electrodes for receiving output signals from the functional blocks 11 and 12 or the electrodes for applying signals from the outside of the semiconductor device 1 to the functional blocks 11 and 12 are provided around the upper surface of the semiconductor chip 21 as described in the first embodiment. The signal terminals 54 of the package 52 are electrically connected to some of the above-mentioned electrodes through aluminum wires.

An input signal from the outside of the semiconductor device 51 and an output signal from the functional blocks 11 and 12 are applied to the signal terminals 54 connected to the functional blocks 11 and 12. This allows the signal from an external device to be provided to the functional blocks 11 and 12, and allows an external device to receive the output signal from the functional blocks 11 and 12.

The ground terminal 66, the power supply terminal 8 and the signal terminals 4 and 54 are provided on the bottom surface of the package 52. The ground terminal 36 surrounds the ground terminal 35 and the signal terminals 54.

As shown in Figs. 8 and 10, the molding resin 53 seals the semiconductor chip 21, the insulating substrate 42, the ground terminal 66, the power supply terminal 8, the signal terminals 4 and 54 and the aluminum wires 43 while exposing the ground terminal 66, the power supply terminal 8 and the signal terminals 4 and 54. The remaining structures of the semiconductor device 51 according to the third embodiment are similar to those of the semiconductor device 31 according to the second embodiment, and will not be described.

In the semiconductor device 51 according to the third embodiment, as described above, the ground terminal 36 surrounds also the signal terminals 54. Thus, the potentials at not only the ground terminal 35 but also the signal terminals 54 are less susceptible to a potential change at the signal terminals 4.

In the semiconductor device 31 according to the second embodiment, when a clock signal of tens of megahertz is applied to one of two adjacent signal terminals 4 and an analog signal having a very low signal level, e.g. a very faint radio signal received by the antenna, is inputted to the other of the two adjacent signal terminals 4, a potential change at the one signal terminal 4 applied with the clock signal might vary the potential at the other signal terminal 4 applied with the radio signal. This might preclude the functional block 12 applied with the radio signal from properly processing the radio signal.

Because of the provision of the signal terminals 54 surrounded by the ground terminal 36 in the third embodiment, assigning the above-mentioned signal susceptible to noises to the signal terminals 54 ameliorates the problem such that the signal is not properly processed inside or outside the semiconductor device 51 due to the potential change at the signal terminals 4. Consequently, the third embodiment achieves higher performance than the semiconductor device 31 of the second embodiment.

Although the single power supply terminal 8 for supplying power to the semiconductor integrated circuit 10 is provided in the first to third embodiments, a plurality of power supply terminals 8 may be provided around the ground terminal.

The digital circuit and the analog circuit are adopted for the functional blocks 11 and 12 provided in the semiconductor integrated circuit 10 in the above description. However, functional blocks which perform other functions may be employed. As an example, when the above-mentioned semiconductor devices 1, 31 and 51 are adopted for a superheterodyne receiver, a circuit for processing an RF (Radio Frequency) signal may be used as the functional block 11, and a circuit for processing an IF (Intermediate Frequency) signal be used as the functional block 12.

Specific examples of the circuit for processing the RF signal include a filter circuit for extracting a desired signal from the RF signal inputted to the signal terminals 4 or the signal terminals 54, an amplifier circuit for amplifying the output from the filter circuit, and a frequency converter circuit for converting the RF signal into the IF signal. Specific examples of the circuit for processing the IF signal include a filter circuit for filtering the IF signal outputted from the circuit for processing the RF signal, an amplifier circuit for amplifying the output from the filter circuit, and a demodulator for demodulating the IF signal to recover an audio signal.

Alternatively, a circuit which conducts a relatively large current ranging from tens of to hundreds of milliamperes may be used as the functional block 11, and a circuit which conducts a relatively small current ranging from several to tens of microamperes be used as the functional block 12. An example of the circuit which conducts a relatively large current includes a loudspeaker amplifier circuit. An example of the circuit which conducts a relatively small current includes the above-mentioned circuit for processing the RF circuit.

Although the semiconductor integrated circuit 10 includes the two functional blocks 11 and 12 in the first to third embodiments, the semiconductor integrated circuit 10 may include three or more functional blocks. As an example, the semiconductor integrated circuit 10 may include two functional blocks each constituted by an analog circuit, and a functional block constituted by a digital circuit. In such a case, isolating the ground terminals for the respective functional blocks from each other in the package improves the performance of each of the functional blocks, thereby improving the performance of the semiconductor device.

While the invention has been shown and described in detail, the foregoing description is in all aspects illustrative and not restrictive. It is therefore understood that numerous modifications and variations can be devised without departing from the scope of the invention.

## Claims

1. A semiconductor device comprising:
a semiconductor integrated circuit having a first functional block and a second functional block;
a package for storing said semiconductor integrated circuit therein; and
a ground terminal and signal terminals exposed to the outside of said package,
said ground terminal including first and second ground terminals isolated from each other,
said signal terminals including a plurality of first signal terminals arranged around said ground terminal,
said first ground terminal being electrically connected to said first functional block,
said second ground terminal being electrically connected to said second functional block.

2. The semiconductor device according to claim 1, wherein
said second ground terminal surrounds said first ground terminal.

3. The semiconductor device according to claim 2, wherein
said signal terminals include a second signal terminal, and
said second ground terminal further surrounds said second signal terminal.
